# EUROPEAN PATENT APPLICATION

(11) **EP 2 151 857 A2**
(43) Date of publication of application: **10.02.2010**
(21) Application number: 09166861.6
(22) Date of filing: 30.07.2009
(51) Int. Cl.: H01L 21/58, H01L 21/68, C09J 7/02

(54) **Dicing die-bonding film**

(30) Priority: 04.08.2008 JP 2008200973
(71) Applicant: NITTO DENKO CORPORATION, Ibaraki-shi, Osaka 567-8680 (JP)
(72) Inventor: Kamiya, Katsuhiko, Ibaraki-shi Osaka 567-8680 (JP); Matsumura, Takeshi, Ibaraki-shi Osaka 567-8680 (JP); Murata, Shuuhei, Ibaraki-shi Osaka 567-8680 (JP); Ootake, Hironao, Ibaraki-shi Osaka 567-8680 (JP)
(74) Representative: Sajda, Wolf E.

(57) **Abstract**

A dicing die-bonding film of the present invention has a dicing film having a pressure-sensitive adhesive layer (2) on a base (1) and a die-bonding film (3) provided on the pressure-sensitive adhesive layer (2), wherein the pressure-sensitive adhesive layer (2) is formed from an acrylic polymer comprising an acrylic ester A represented by CH₂=CHCOOR¹ (wherein R¹ is an alkyl group having 6 to 10 carbon atoms), an acrylic ester B represented by CH₂=CHCOOR² (wherein R² is an alkyl group having 11 carbon atoms or more), a hydroxyl group-containing monomer, and an isocyanate compound having a radical reactive carbon-carbon double bond within a molecule, the compounded ratio of the acrylic ester A and the acrylic ester B is 40 to 10 mol% of the acrylic ester B to 60 to 90 mol% of the acrylic ester A, the compounded ratio of the hydroxyl group-containing monomer is in a range of 10 to 30 mol% to 100 mol% of the total of the acrylic ester A and the acrylic ester B, the compounded ratio of the isocyanate compound is in a range of 70 to 90 mol% to 100 mol% of the hydroxyl group-containing monomer, and the die-bonding film is formed from an epoxy resin.

## Description

### BACKGROUND OF THE INVENTION

### Field of the Invention

The present invention relates to a dicing die-bonding film that is used in dicing of a workpiece under a condition where an adhesive for fixing a chip-shaped workpiece such as a semiconductor chip and an electrode member is pasted onto a workpiece such as a semiconductor wafer before dicing.

### Description of the Related Art

A semiconductor wafer (workpiece) on which a circuit pattern is formed is diced into semiconductor chips (chip-shaped workpieces) (a dicing step) after the thickness thereof is adjusted by backside polishing as necessary. In the dicing step, it is common to wash the semiconductor wafer at an appropriate liquid pressure (normally, about 2 kg/cm²) to remove a cut layer. Next, the semiconductor chips are fixed onto an adherend such as a lead frame with an adhesive (a mounting step), and then they are transferred to a bonding step. In the mounting step, the adhesive is applied onto the lead frame or the semiconductor chip.
However, this method can hardly make an adhesive layer uniform, and a special apparatus and a long time are necessary for the application of the adhesive. Accordingly, a dicing die-bonding film is proposed that provides an adhesive layer for fixing chips that is necessary in the mounting step while adhering and holding a semiconductor wafer in the dicing step (for example, refer to Japanese Patent Application Laid-Open JP-A-60-057 642).

The dicing die-bonding film described in Japanese Patent Application Laid-Open JP-A-60-057 642 provides a peelable adhesive layer onto a support base. That is, the semiconductor wafer is diced while being held by the adhesive layer, the semiconductor chips are peeled off together with the adhesive layer by stretching the support base, and the individual semiconductor chips are collected and fixed onto an adherend such as a lead frame with the adhesive layer in between.

A good holding strength toward the semiconductor wafer and a good peeling property such that the semiconductor chips after dicing and the adhesive layer can be peeled off a support base integrally are desired for an adhesive layer of a dicing die-bonding film of this type so that a dicing impossibility, a dimensional error, or the like does not occur. However, it has never been easy to balance both characteristics. In particular, when a large holding strength is required in the adhesive layer such as in a method of dicing a semiconductor wafer with a rotary circular blade, or the like, it is difficult to obtain a dicing die-bonding film that satisfies the above-described characteristics.

Then, in order to overcome such problems, various improved methods have been proposed (for example, refer to Japanese Patent Application Laid-Open JP-A-2-248064). In this document, a method is proposed that makes picking up of a semiconductor chip easy by providing an ultraviolet-ray curable pressure-sensitive adhesive layer between the support base and the adhesive layer, decreasing the adhering strength between the pressure-sensitive adhesive layer and the adhesive layer by curing the product with an ultraviolet ray after dicing, and peeling the two layers from each other.

However, even with this improved method, there is a case that it is difficult to have a dicing die-bonding film in which the holding strength during dicing and the peeling property after dicing is balanced well. For example, in the case of a large semiconductor chip that is 10 mm x 10 mm or more or a very thin semiconductor chip 25 to 50 µm in thickness, the semiconductor chip cannot be picked up easily with a general die bonder because of the large area.

### SUMMARY OF THE INVENTION

The present invention has been made in view of the above-described problems, and an object thereof is to provide a dicing die-bonding film including a dicing film having a pressure-sensitive adhesive layer on a base and a die-bonding film provided on the pressure-sensitive adhesive layer, and even when the semiconductor wafer is thin, having balanced characteristics of holding strength when dicing the thin semiconductor wafer and peeling properties when peeling off the semiconductor chip that is obtained by dicing and its die-bonding film integrally.

The inventors of the present invention investigated a dicing die-bonding film to solve the conventional problems. As a result, they found that the pickup property deteriorates due to disappearance of the interface between the dicing film and the die-bonding film by material diffusion of a multi-functional monomer component that is contained in the dicing film into the die-bonding film, and completed of the present invention.

That is, in order to solve the above-mentioned problems, the present invention relates to a dicing die-bonding film comprising a dicing film having a pressure-sensitive adhesive layer on a base and a die-bonding film provided on the pressure-sensitive adhesive layer, wherein the pressure-sensitive adhesive layer is formed from an acrylic polymer comprising an acrylic ester A represented by CH₂=CHCOOR¹ (wherein R¹ is an alkyl group having 6 to 10 carbon atoms), an acrylic ester B represented by CH₂=CHCOOR² (wherein R² is an alkyl group having 11 carbon atoms or more), a hydroxyl group-containing monomer, and an isocyanate compound having a radical reactive carbon-carbon double bond within a molecule, the compounded ratio of the acrylic ester A and the acrylic ester B is 40 to 10 mol% of the acrylic ester B to 60 to 90 mol% of the acrylic ester A, the compounded ratio of the hydroxyl group-containing monomer is in a range of 10 to 30 mol% to 100 mol% of the total of the acrylic ester A and the acrylic ester B, the compounded ratio of the isocyanate compound is in a range of 70 to 90 mol% to 100 mol% of the hydroxyl group-containing monomer, and the die-bonding film is formed from an epoxy resin.

An acrylic polymer that forms the pressure-sensitive adhesive layer of the present invention contains an acrylic ester A represented by CH₂=CHCOOR¹ (wherein R¹ is an alkyl group having 6 to 10 carbon atoms) and an acrylic ester B represented by CH₂=CHCOOR (wherein R² is an alkyl group having 11 carbon atoms or more) at a compounded ratio of 40 to 10 mol% of the acrylic ester B to 60 to 90 mol% of the acrylic ester A. By making the compounded ratio of the acrylic ester A 90 mol% or less and making the compounded ratio of the acrylic ester B 10 mol% or more, the peeling properties after ultraviolet-ray curing of the pressure-sensitive adhesive layer to the die-bonding film can be improved and the pickup property when picking up the semiconductor chip is made good.
On the other hand, by making the compounded ratio of the acrylic ester A 60 mol% or more and making the compounded ratio of the acrylic ester B 40 mol% or less, tackiness of the dicing film and the die-bonding film before the ultraviolet-ray curing is made good and peeling can be prevented. Further, by making the compounded ratio of a hydroxyl group-containing monomer 10 mol% or more to 100 mol% of the total of the acrylic ester A and the acrylic ester B, crosslinking after the ultraviolet-ray curing is prevented from being insufficient.
As a result, an adhesive residue is prevented from occurring on a dicing ring that is pasted onto the pressure-sensitive adhesive layer upon dicing, for example. On the other hand, by making the compounded ratio 30 mol% or less, difficulty in peeling due to excessive crosslinking by the ultraviolet ray irradiation and deterioration in the pickup property can be prevented.

Further, because an isocyanate compound having a radical reactive carbon-carbon double bond within a molecule is adopted in place of the multi-functional monomer in the present invention, there is no material diffusion of the multi-functional monomer into the die-bonding film. As a result, the interface between the dicing film and the die-bonding film is prevented from disappearing, and an even better pickup property is made possible.

It is also preferable that the hydroxyl group-containing monomer is at least any one selected from a group consisting of 2-hydroxyethyl (meth)acrylate, 2-hydroxypropyl (meth)acrylate, 4-hydroxybutyl (meth)acrylate, 6-hydroxyhexyl (meth)acrylate, 8-hydorxyoctyl (meth)acrylate, 10-hydroxydecyl (meth)acrylate, 12-hydroxylauryl (meth)acrylate, and (4-hydroxymethylcyclohexyl)methyl (meth)acrylate.

It is also preferable that the isocyanate compound having a radical reactive carbon-carbon double bond is at least one of 2-methacryloyloxyethyl isocyanate and 2-acrylolyloxyethyl isocyanate.

It is also preferable that the weight average molecular weight of the acrylic polymer is in a range of 350,000 to 1,000,000. By making the weight average molecular weight 350,000 or more, the acrylic polymer is prevented from becoming a low molecular weight polymer. Accordingly, peeling from the dicing ring that is pasted onto the pressure-sensitive adhesive layer can be prevented from occurring during dicing, for example. Furthermore, because the crosslinking after the ultraviolet ray irradiation is prevented from becoming insufficient, the adhesive residue can be prevented from occurring when peeling the dicing ring off the pressure-sensitive adhesive layer.
On the other hand, by making the weight average molecular weight 1,000,000 or less, workability when forming the pressure-sensitive adhesive layer onto a base can be improved. The formation of the pressure-sensitive adhesive layer is performed by applying a solution of a pressure-sensitive adhesive composition that is formed from the acrylic polymer onto a base and then drying the solution, for example. This is because the workability during polymerization of the acrylic polymer and application decreases when the weight average molecular weight of the acrylic polymer exceeds 1,000,000 since the viscosity of the solution of the pressure-sensitive adhesive composition becomes too high.

It is preferable that the tensile modulus at 23 °C of the pressure-sensitive adhesive layer before ultraviolet irradiation is in a range of 0.4 to 3.5 MPa and the tensile modulus at 23 °C after ultraviolet irradiation is in a range of 7 to 100 MPa. By making the tensile modulus (23 °C) before ultraviolet ray irradiation 0.4 MPa or more, the fixing of the semiconductor chip when dicing the semiconductor wafer is made good, and as a result, chipping can be prevented from occurring. Further, when peeling the dicing ring, the adhesive residue can be prevented from occurring. On the other hand, by making the tensile modulus (23 °C) 3.5 MPa or less, chip fly can be prevented from occurring during dicing. Further, by making the tensile modulus (23 °C) after ultraviolet ray irradiation 7 MPa or more, the pickup property can be improved.

It is preferable that the acrylic polymer constituting the pressure-sensitive adhesive layer does not contain an acrylic acid as a monomer component. With this constitution, reaction or interaction of the pressure-sensitive adhesive layer and the die-bonding film can be prevented, and the pickup property can be further improved.

### BRIEF DESCRIPTION OF THE DRAWINGS

- Fig. 1: is a cross-sectional schematic drawing showing a dicing die-bonding film according to one embodiment of the present invention;
- Fig. 2: is a cross-sectional schematic drawing showing another dicing die-bonding film according to another embodiment of the present invention;
- Fig. 3A: is a cross-sectional schematic drawing showing an example in which a semiconductor wafer is mounted on the dicing die-bonding film with the die-bonding film interposed therebetween.
- Fig. 3B: is a cross-sectional schematic drawing showing an example in which the semiconductor wafer is diced into semiconductor chips.
- Fig. 3C: is a cross-sectional schematic drawing showing an example in which the semiconductor chip is pushed up with a needle.
- Fig. 3D: is a cross-sectional schematic drawing showing an example in which the semiconductor chip is picked up.
- Fig. 3E: is a cross-sectional schematic drawing showing an example in which the semiconductor chip is adhered and fixed to an adhered, and furthermore, the semiconductor chip is sealed with a sealing resin.

### DETAILED DESCRIPTION OF THE PREFERRED EMBODIMENTS

### Dicing Die-Bonding Film

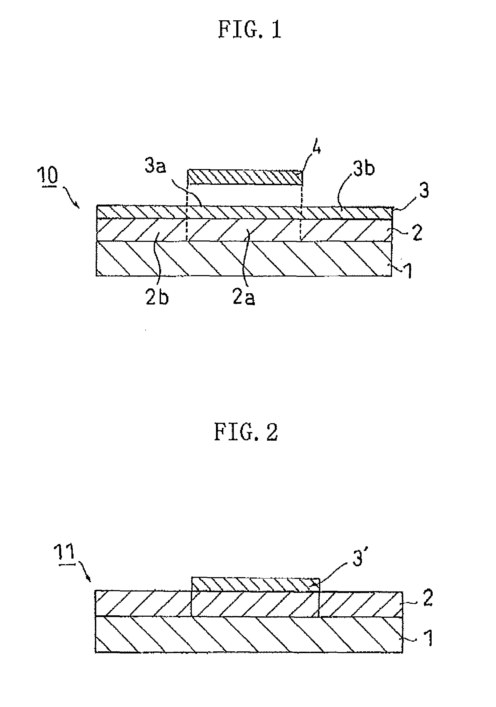

An embodiment of the present invention is described referring to Figs. 1 and 2. Fig. 1 is a sectional schematic drawing showing a dicing die-bonding film of the present embodiment. Fig. 2 is a sectional schematic drawing showing another dicing die-bonding film of the present embodiment. Parts that are unnecessary to explain are omitted, and there are parts that are drawn by magnifying or minifying to make the explanation easy.

As shown in Fig. 1, a dicing die-bonding film 10 has a configuration having a dicing film in which a pressure-sensitive adhesive layer 2 is provided on a base 1 and a die-bonding film 3 on the pressure-sensitive adhesive layer 2. Alternatively, as shown in Fig. 2, the present invention may have a configuration in which a die-bonding film 3' is formed only on a semiconductor wafer pasting portion.

The base 1 confers strength on the dicing die-bonding film 10, 11. Examples of the base film include polyolefins such as low-density polyethylene, linear polyethylene, middle-density polyethylene, high-density polyethylene, ultra-low-density polyethylene, random copolymerization polypropylene, block copolymerization polypropylene, homopolypropylene, polybutene, polymethyl pentene etc., polyesters such as ethylene/vinyl acetate copolymer, ionomer resin, ethylene/(meth)acrylic acid copolymer, ethylene/(meth)acrylate (random, alternating) copolymer, ethylene/butane copolymer, ethylene/hexene copolymer, polyurethane, polyethylene terephthalate, polyethylene naphthalate etc., polycarbonate, polyimide, polyether ether ketone, polyimide, polyether imide, polyamide, every aromatic polyamide, polyphenyl sulfide, aramid (paper), glass, glass cloth, fluorine resin, polyvinyl chloride, polyvinylidene chloride, cellulose resin, silicone resin, metal (foil), paper etc.

Further, an example of a material of the base 1 is a polymer such as a crosslinked body of the above-described resins. When the base 1 is composed of a plastic film, the plastic film may be used in a non-stretched form or after subjection if necessary to uniaxial or biaxial stretching treatment. According to a resin sheet endowed with thermal shrinkability by stretching treatment, the base 1 can be thermally shrunk after dicing thereby reducing the contact area between the pressure-sensitive adhesive layer 2 and the die-bonding film 3,3 ' to facilitate the recovery of semiconductor chips.

The surface of the base 1 can be subjected to ordinary surface treatment for improving adhesion and maintenance of the adjacent layer, for example chemical or physical treatment such as treatment with chromate, exposure to ozone, exposure to flames, high-voltage electric shock exposure, and treatment with ionization radiations, or coating treatment with a undercoat (for example, a sticky material described later).

The same or different kinds of the base 1 can be suitably selected and used. The substrate material may be a single layer or multilayer or may be a blend substrate material having two or more kinds of resins dry-blended therein. The multilayer film can be produced from the above resin etc. by a conventional film lamination method such as co-extrusion method, dry lamination method etc.
The base 1 can be provided thereon with a evaporated layer of about 30 to 500 Å consisting of an electroconductive material such as a metal, an alloy and an oxide thereof in order to confer antistatic performance. The base 1 may be a single layer or a multilayer consisting of two or more layers.

The thickness of the base 1 can be suitably determined without particular limitation, and is generally preferably about 5 to 200 µm.

The pressure-sensitive adhesive layer 2 is formed from an ultraviolet-ray curing-type pressure-sensitive adhesive. The ultraviolet-ray curing-type pressure-sensitive adhesive can easily decrease its adhesive strength by increasing the degree of crosslinking by irradiation of an ultraviolet ray, and by irradiating only a portion 2a corresponding to the semiconductor wafer pasting portion of the pressure-sensitive adhesive layer 2 shown in Fig. 2 with an ultraviolet ray, a difference in the adhesive strength compared to another portion 2b can be provided.

Further, by curing the ultraviolet-ray curing-type pressure-sensitive adhesive layer 2 matching to the shape of the die-bonding film 3' shown in Fig. 2, the portion 2a of which the adhesive strength is remarkably decreased can be easily formed. Because the die-bonding film 3' is pasted onto the portion 2a which has been cured and of which the adhesive strength has been decreased by curing, the interface of the portion 2a of the pressure-sensitive adhesive layer 2 with the die-bonding film 3' has a property of being easily peeled during pickup. On the other hand, a portion not irradiated with the ultraviolet ray has sufficient adhesive strength, and forms the portion 2b.

As described above, in the pressure-sensitive adhesive layer 2 of the dicing die-bonding film 10 shown in Fig. 1, the portion 2b that is formed from a non-cured ultraviolet-ray curing-type pressure-sensitive adhesive adheres to the die-bonding film 3, and the holding strength upon dicing can be secured. In such a way, the ultraviolet-ray curing-type pressure-sensitive adhesive can support the die-bonding film 3 for fixing a semiconductor chip to an adhered such as a substrate with a good balance of adhesion and peeling. In the pressure-sensitive adhesive layer 2 of a dicing die-bonding film 11 shown in Fig. 2, the portion 2b can fix a dicing ring. A dicing ring that is made from a metal such as stainless steel or a resin can be used, for example.

The ultraviolet-ray curing-type pressure-sensitive adhesive is an internal-type ultraviolet-ray curing-type pressure-sensitive adhesive that uses a base polymer having a radical reactive carbon-carbon double bond in a polymer side chain or main chain or ends of the main chain. Because the internal-type ultraviolet-ray curing-type pressure-sensitive adhesive does not have to include or does not include in a large amount an oligomer component or the like that is a low molecular weight component, the oligomer component or the like does not travel in the pressure-sensitive adhesive over time, and a pressure-sensitive adhesive layer having a stable layer structure can be formed.

In the present invention, the acrylic polymer includes the acrylic ester A, the acrylic ester B, the hydroxyl group-containing monomer, and the isocyanate compound having a radical reactive carbon-carbon double bond within a molecule.

The acrylic ester A is represented by a chemical formula CH₂=CHCOOR¹ (wherein R¹ is an alkyl group having 6 to 10 carbon atoms, more preferably having 8 to 9 carbon atoms). The acrylic ester B is represented by a chemical formula CH₂=CHCOOR² (wherein R² is an alkyl group having I 1 carbon atoms or more, more preferably having 12 to 26 carbon atoms, and further preferably 16 to 22 carbon atoms). By including such a long-chain alkyl monomer, polarity of the pressure-sensitive adhesive is reduced, and the peeling properties after ultraviolet-ray curing can be improved.

The compounded ratio of the acrylic ester A and the acrylic ester B is 40 to 10 mol% of the acrylic ester B to 60 to 90 mol% of the acrylic ester A. When the compounded ratio of the acrylic ester A exceeds 90 mol% and the compounded ratio of the acrylic ester B becomes less than 10 mol%, the peeling property of the pressure-sensitive adhesive layer 2 after ultraviolet-ray curing to the die-bonding film 3 deteriorates and deterioration of the pickup property is brought about when picking up the semiconductor chip. On the other hand, when the compounded ratio of the acrylic ester A becomes less than 60 mol% and the compounded ratio of the acrylic ester B exceeds 40 mol%, tackiness of the pressure-sensitive adhesive layer 2 to the die-bonding film 3 decreases and there is a case that chip fly occurs upon dicing.

Specific examples of the acrylic ester A include acrylic alkyl esters in which an alkyl group has 6 to 10 carbon atoms, especially 8 to 9 carbon atoms, such as acrylic hexyl ester, acrylic heptyl ester, acrylic octyl ester, acrylic 2-ethylhexyl ester, acrylic isooctyl ester, acrylic nonyl ester, acrylic isononyl ester, acrylic decyl ester, acrylic isodecyl ester. Furthermore, among the monomers represented by the above-described chemical formulae, acrylic 2-ethylhexyl and acrylic isooctyl are especially preferable.

The acrylic ester B may be any acrylic alkyl esters that an alkyl group has 11 carbon atoms or more. The alkyl group preferably has 12 carbon atoms or more, especially 16 carbon atoms. The upper limit of the number of the alkyl group is not particular limitation. The alkyl group preferably has 30 carbon atoms or less, more preferably 26 carbon atoms or less, especially 22 carbon atoms or less. Specific examples of the acrylic ester B include dodecyl acrylate, tridecyl acrylate, tetradecyl acrylate, hexadecyl acrylate, octadecyl acrylate, eicosyl acrylate and behenyl acrylate. These monomers may be used alone or two types or more may be used together.

A hydroxyl group-containing monomer that is capable of copolymerizing with the acrylic ester A and the acrylic ester B is used in the acrylic polymer as an essential component. Examples of the hydroxyl group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)aerylate. These hydroxyl group-containing monomers may be used alone or two types or more may be used together.

The compounded ratio of the hydroxyl group-containing monomer is preferably in a range of 10 to 30 mol%, more preferably in a range of 15 to 25 mol% of the total of the acrylic ester A and the acrylic ester B. When the compounded ratio is less than 10 mol%, crosslinking after ultraviolet-ray curing becomes insufficient, and there is a case that an adhesive residue occurs to the dicing ring that is pasted on the pressure-sensitive adhesive layer upon dicing. On the other hand, when the compounded ratio exceeds 30 mol%, peeling becomes difficult because the polarity of the pressure-sensitive adhesive becomes high and the interaction with the die-bonding film becomes intense.

The acrylic polymer may include a unit corresponding to another monomer component that is capable of copolymerizing with the acrylic alkyl ester as necessary for the purpose of improving cohesive strength and heat resistance. Examples of such a monomer component include acrylic alkyl esters in which an alkyl group has 1 to 5 carbon atoms, such as methyl acrylate, ethyl acrylate, propyl acrylate, isopropyl acrylate, butyl acrylate, isobutyl acrylate, t-butyl acrylate, s-butyl acrylate and pentyl acrylate; methacrylic alkyl esters in which an alkyl group has 1 to 5 carbon atoms, such as methyl methacrylate, ethyl methacrylate, propyl methacrylate, isopropyl methacrylate, butyl methacrylate, isobutyl methacrylate, t-butyl methacrylate, s-butyl methacrylate and pentyl methacrylate; carboxyl group-containing monomers such as acrylic acid, methacrylic acid, carboxyethyl (meth)aerylate, carboxylpentyl (meth)acrylate, itaconic acid, maleic acid, fumaric acid, and crotonic acid; acid anhydride monomers such as maleic anhydride and itaconic anhydride; sulfonic acid group-containing monomers such as stylenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphate group-containing monomers such as 2-hydroxyethylacryloylphosphate; acrylamide; and acrylnitrile. One type or two types or more of these copolymerizable monomer components can be used.
The amount of use of these copolymerizable monomers is preferably 40% by weight or less to the total monomer components. However, in the case of the carboxyl group-containing monomers, by its carboxyl group reacting with an epoxy group in an epoxy resin in the die-bonding film 3, the interface of the pressure-sensitive adhesive layer 2 and the die-bonding film 3 disappears, and the peeling property of both the pressure-sensitive adhesive layer 2 and the die-bonding film 3 may deteriorate.
Therefore, the amount of use of the carboxyl group-containing monomers is preferably 0 to 3% by weight or less of the total monomer component. Further, among these monomer components, the acrylic polymer constituting the pressure-sensitive adhesive layer 2 of the present invention preferably does not include acrylic acid as a monomer component. There is a case that the peeling property deteriorates by disappearance of the interface between the pressure-sensitive adhesive layer 2 and the die-bonding film 3 by material diffusion of acrylic acid into the die-bonding film 3.

Here, the acrylic polymer does not preferably include a multi-functional monomer as a monomer component for copolymerization. With this constitution, there is no material diffusion of the multi-functional monomer into the die-bonding film, the deterioration of the pick up property due to disappearance of the interface of the pressure-sensitive adhesive layer 2 and the die-bonding film 3 disappearing can be prevented.

Further, an isocyanate compound having a radical reactive carbon-carbon double bond within a molecule is used in the acrylic polymer as an essential component. Examples of the isocyanate compound include methacryloyl isocyanate, 2-methacryloyloxyethyl isocyanate, 2-acryloyloxyethyl isocyanate, and m-isopropenyl-α,α-dimethylbenzyl isocyanate. These isocyanate compound may be used alone or two types or more may be used together.

The compounded ratio of the isocyanate compound having a radial reactive carbon-carbon double bond is preferably in a range of 70 to 90 mol%, and more preferably in a range of 75 to 85 mol% to 100 mol% of the hydroxyl group-containing monomer,.
When the compounded ratio is less than 70 mol%, crosslinking after ultraviolet-ray curing becomes insufficient, and an adhesive residue occurs to the dicing ring that is pasted on the pressure-sensitive adhesive layer upon dicing. On the other hand, when the compounded ratio exceeds 90 mol%, peeling becomes difficult because the polarity of the pressure-sensitive adhesive becomes high and the interaction with the die-bonding film becomes intense, and the pickup property deteriorates.

The acrylic polymer can be obtained by polymerizing the monomer mixture described above. The polymerization can be performed by any of the methods such as solution polymerization, emulsion polymerization, bulk polymerization, and suspension polymerization. The content of a low molecular weight material is preferably small from the viewpoint of minimizing the contamination of a clean adherend, or the like. In this respect, the weight average molecular weight of the acrylic polymer is preferably 350,000 to 1,000,000, and more preferably about 450,000 to 800,000. The measurement of the weight average molecular weight is performed by GPC (Gel Permeation Chromatography), and the value of the weight average molecular weight is calculated by polystyrene conversion.

Further, an external crosslinking agent can be appropriately adopted in the pressure-sensitive adhesive to adjust the adhesive strength before and after the ultraviolet ray irradiation. A specific method of external crosslinking is a method of adding and reacting a so-called crosslinking agent such as a polyisocyanate compound, an epoxy compound, an aziridine compound, or a melamine-based crosslinking agent.
In the case of using an external crosslinking agent, its amount of use is appropriately determined by a balance with the base polymer that has to be crosslinked and further by the usage as a pressure-sensitive adhesive. In general, the amount is about 20 parts by weight or less to 100 parts by weight of the base polymer, and further, it is preferably compounded at 0.1 to 10 parts by weight. Furthermore, various conventionally known additives such as a tackifier and an anti-aging agent other than the above-described components may be used in the pressure-sensitive adhesive as necessary.

The method of introducing the radical reactive carbon-carbon double bond to the acrylic polymer is not especially limited, and various methods can be adopted. However, it is easy to introduce the radical reactive carbon-carbon double bond to the polymer side chain from the viewpoint of molecular design. An example thereof is a method of copolymerizing a monomer having a hydroxyl group to an acrylic polymer in advance and performing a condensation or addition reaction on the isocyanate compound having an isocyanate group that can react with this hydroxyl group and a radical reactive carbon-carbon double bond while maintaining the ultraviolet-ray curing property of the radical reactive carbon-carbon double bond.

In the internal type ultraviolet-ray curing-type pressure-sensitive adhesive, the base polymer (especially an acrylic polymer) having a radical reactive carbon-carbon double bond can be used alone. However, an ultraviolet-ray curable monomer component and an oligomer component may also be compounded at a level not deteriorating the characteristics.

The radiation-curing monomer component to be compounded includes, for example, urethane oligomer, urethane (meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butane diol di(meth)acrylate, tetraethylene glycol di(meth)acrylate, 1,6-hexane diol (meth)acrylate, neopentyl glycol di(meth)acrylate etc.; ester acrylate oligomers; and isocyanurates or isocyanurate compounds such as 2-propenyl-3-butenyl cyanurate, tris(2-methacryloxyethyl) isocyanurate etc.
The radiation-curing oligomer component includes various acrylate oligomers such as those based on urethane, polyether, polyester, polycarbonate, polybutadiene etc., and their molecular weight is preferably in the range of about 100 to 30000. For the compounded amount of the radiation-curable monomer component or oligomer component, the amount of which the adhesive strength of the pressure-sensitive adhesive layer can be decreased can be determined appropriately depending on the type of the above-described pressure-sensitive adhesive layer. In general, the compounded amount is, for example, 5 to 500 parts by weight relative to 100 parts by weight of the base polymer such as an acrylic polymer constituting the pressure-sensitive adhesive, and preferably about 40 to 150 parts by weight.

For curing with UV rays, a photopolymerization initiator preferably is incorporated into the radiation-curing pressure-sensitive adhesive. The photopolymerization initiator includes, for example, α-ketol compounds such as 4-(2-hydroxyethoxy)phenyl(2-hydroxy-2-propyl)ketone, α-hydroxy-α,α'-dimethyl acetophenone, 2-methyl-2-hydroxypropiophenone, 1-hydroxycyclohexyl phenyl ketone etc.; acetophenone compounds such as methoxyacetophenone, 2,2-dimethoxy-2-phenylacetophenone, 2,2-diethoxyacetophenone, 2-methyl-1-[4-(methylthio)-phenyl]-2-morpholinopropane-1 etc.; benzoin ether compounds such as benzoin ethyl ether, benzoin isopropyl ether, anisoin methyl ether etc.; ketal compounds such as benzyl dimethyl ketal etc.; aromatic sulfonyl chloride compounds such as 2-naphthalene sulfonyl chloride etc.; optically active oxime compounds such as 1-phenone-1,1-propanedione-2-(o-ethoxycarbonyl)oxime etc.; benzophenone compounds such as benzophenone, benzoylbenzoic acid, 3,3'-dimethyl-4-methoxybenzophenone etc.; thioxanthone compounds such as thioxanthone, 2-chlorothioxanthone, 2-methyl thioxanthone, 2,4-dimethyl thioxanthone, isopropyl thioxanthone, 2,4-dichlorothioxanthone, 2,4-diethyl thioxanthone, 2,4-diisopropyl thioxanthone etc.; camphor quinone; halogenated ketone; acyl phosphinoxide; acyl phosphonate etc.
The amount of the photopolymerization initiator to be incorporated is for example about 0.05 to 20 parts by weight, based on 100 parts by weight of the base polymer such as acrylic polymer etc. constituting the pressure-sensitive adhesive.

In the pressure-sensitive adhesive layer 2 of the dicing die-bonding film 10, a part of the pressure-sensitive adhesive layer 2 may be irradiated with the ultraviolet ray so that the adhesive strength of the portion 2a becomes smaller than the adhesive strength of another portion 2b. That is, the portion 2a can be formed where the adhesive strength is decreased by using the base 1 of which the entire or a part of the portion other than the portion corresponding to the semiconductor wafer pasting portion 3a on at least one side of the base 1 is shielded, forming the ultraviolet-ray curing-type pressure-sensitive adhesive layer 2 onto the base 1, and then curing the portion corresponding to the semiconductor wafer pasting portion 3a by ultraviolet ray irradiation.
As the shielding material, a material that can be a photo mask on a support film can be manufactured by printing, vapor deposition, or the like. Further, the cumulative radiation of the ultraviolet ray is preferably 50 to 500 mJ/cm². By making the cumulative radiation in this range, tackiness is maintained at a level that the generation of fly of the semiconductor chip can be prevented upon dicing, and at the same time, a good pickup property can be obtained upon picking up. With this constitution, the dicing die-bonding film 10 of the present invention can be manufactured efficiently.

When an impediment to curing due to oxygen occurs during the ultraviolet ray irradiation, it is desirable to shut off oxygen (air) from the surface of the ultraviolet-ray curing-type pressure-sensitive adhesive layer 2. Examples of the shut-off method include a method of coating the surface of the pressure-sensitive adhesive layer 2 with a separator and a method of performing irradiation with the ultraviolet ray in a nitrogen gas atmosphere.

The thickness of the pressure-sensitive adhesive layer 2 is not especially limited. However, it is preferably about 1 to 50 µm from the viewpoint of achieving both the prevention of the breakage of the chip cut face and the fixing and holding of the adhesive layer. The thickness is more preferably 2 to 30 µm, and further preferably 5 to 25 µm.

The die-bonding film 3 can be configured as only a single adhesive layer, for example. Further, the die-bonding film 3 may be of a multi-layer structure of two layers or more by appropriately combining thermoplastic resins having different glass transition temperatures and thermosetting resins having different thermosetting temperatures. Because cutting water is used in the dicing step of the semiconductor wafer, the die-bonding film 3 absorbs moisture, and there is a case that water is contained more than usual.
When the die-bonding film 3 is adhered to the substrate or the like at such a high water content, water vapor accumulates on the adhesion interface at the after curing stage, and there is a case that floating occurs. Therefore, such a problem can be avoided by making the adhesive for adhering the die have a configuration in which a core material having high moisture permeability is sandwiched with the die adhesive and making the water vapor diffuse through the film at the after curing stage. From such a viewpoint, the die-bonding film 3 may have a multi-layer structure in which the adhesive layer is formed on one side or both sides of the core material.

The core material includes films such as a polyimide film, a polyester film, a polyethylene terephthalate film, a polyethylene naphthalate film, and a polycarbonate film, a glass fiber, a resin substrate reinforced with a plastic non-woven fiber, a silicon substrate, and a glass substrate.

The die-bonding film 3 according to the present invention is comprised by containing an epoxy resin as a main component. The epoxy resin is preferable from the viewpoint of containing fewer ionic impurities, etc. that corrode a semiconductor element. The epoxy resin is not particularly limited as long as it is generally used as an adhesive composition, and for example, a difunctional epoxy resin and a polyfunctional epoxy resin of such as a bispehnol A type, a bisphenol F type, a bisphenol S type, a brominated bisphenol A type, a hydrogenated bisphenol A type, a bisphenol AF type, a biphenyl type, a naphthalene type, a fluorine type, a phenol novolak type, an ortho-cresol novolak type, a trishydroxyphenylmethane type, and a tetraphenylolethane type epoxy resin or an epoxy resin of such as a hydantoin type, a trisglycidylisocyanurate type and a glycidylamine type epoxy resin are used.
These can be used alone or two or more types can be used in combination. Among these epoxy resins, a novolak type epoxy resin, a biphenyl type epoxy resin, a trishydroxyphenylmethane type resin, and a tetraphenylolethane type epoxy resin are particularly preferable. This is because these epoxy resins have high reactivity with a phenol resin as a curing agent, and are superior in heat resistance, etc,

Further, other thermosetting resins and thermoplastic resins can be used together in the die-bonding film 3 appropriately as necessary. Examples of the thermosetting resins include phenol resins, amino resins, unsaturated polyester resins, polyurethane resins, silicone resins, and thermosetting polyimide resins. These resins can be used alone or two types or more can be used together. Further, phenol resins are preferably used as a curing agent for the epoxy resin.

Furthermore, the phenol resins act as a curing agent for the epoxy resin, and examples thereof include novolak phenol resins such as a phenol novolak resin, a phenol aralkyl resin, a cresol novolak resin, a tert-butylphenol novolak resin, and a nonylphenol novolak resin, resol phenol resins, and polyoxystyrenes such as polyparaoxystyrene. These can be used alone or two types or more can be used together. Among these phenol resins, a phenol novolak resin and a phenol aralkyl resin are especially preferable because they can improve connection reliability of a semiconductor device.

The compounded ratio of the epoxy resin and the phenol resin is preferably arranged so that the amount of a hydroxyl group in the phenol resin in 1 equivalent of the epoxy group in the epoxy resin component becomes 0.5 to 2.0 equivalents. The amount is more preferably 0.8 to 1.2 equivalents. That is, when the compounded ratio of both resins becomes out of this range, sufficient curing reaction does not proceed, and the characteristics of the epoxy resin cured compound easily deteriorate.

Examples of the thermoplastic resin include a natural rubber, a butyl rubber, an isoprene rubber, a chloroprene rubber, an ethylene-vinyl acetate copolymer, an ethylene-acrylic acid copolymer, an ethylene-acrylic ester copolymer, a polybutadiene resin, a polycarbonate resin, a thermoplastic polyimide resin, polyamide resins such as 6-nylon and 6,6-nylon, a phenoxy resin, an acrylic resin, saturated polyester resins such as PET and PBT, a polyamideimide resin, and a fluorine resin. These thermoplastic resins can be used alone or two types are more can be used together. Among these thermoplastic resins, especially preferable is an acrylic resin containing a small amount of ionic impurities and having high heat resistance and in which reliability of the semiconductor element can be secured.

The acrylic resin is not especially limited, and examples thereof include a polymer containing one type or two types or more of esters of acrylic acid or methacrylic acid having a straight chain or branched alkyl group having 30 carbon atoms or less, especially 4 to 18 carbon atoms. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group.

Other monomers that form the polymer are not especially limited, and examples thereof include carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauzyl (meth)acrylate, and
(4-hydroxymethylcyclohexyl)-methylacrylate; sulfonic acid group-containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; and phosphoric acid group-containing monomers such as 2-hydroxyethylacryloyl phosphate.

Because the crosslinking is performed in the adhesive layer of the die-bonding film 3 to some extent in advance, a multi-functional compound that reacts with a functional group or the like of the molecular chain ends of the polymer is preferably added as a crosslinking agent upon manufacture. With this constitution, tackiness is improved under a high temperature and the heat resistance is improved.

Moreover, other additives can be appropriately compounded in the adhesive layer of the die-bonding film 3 as necessary. Examples of the other additives include a flame retardant, a silane coupling agent, and an ion trapping agent. Examples of the flame retardant include antimony trioxide, antimony pentoxide, and a brominated epoxy resin. These can be used alone or two types or more can be used together. Examples of the silane coupling agent include β-(3,4-epoxycyclohexyl)ethyltrimethoxysilane,
γ -glycidoxypropyltrimethoxysilane, and γ-glycidoxypropylmethyldiethoxysilane. These compounds can be used alone or two types or more can be used together. Examples of the ion trapping agent include hydrotalcites and bismuth hydroxide. These can be used alone or two types or more can be used together.

The thickness of the die-bonding film 3 is not particularly limited. However, it is about 5 to 100 µm, and preferably about 5 to 50 µm.

The dicing die-bonding film 10, 11 can have an antistatic property. This prevents the generation of static electricity during its adhesion and peeling, and prevents a circuit from being damaged by charging of the workpiece such as a semiconductor wafer due to the static electricity. The antistatic property can be given by an appropriate method such as a method of adding an antistatic agent or a conductive material into the base 1, the pressure-sensitive adhesive layer 2, or the die-bonding film 3, and a method of attaching a conductive layer made of a charge transfer complex, a metal film or the like to the base 1.
Among these methods, a method is preferable in which impurity ions that may change the quality of the semiconductor wafer are hardly generated. Examples of the conductive material (conductive filler) that is compounded to give electric conductivity, to improve thermal conductivity, and the like include sphere-shaped, needle-shaped, and flake-shaped metal powders of silver, aluminum, gold, copper, nickel, conductive alloys or the like, metal oxides of alumina or the like, amorphous carbon black, and graphite. However, the die-bonding film 3, 3' is preferably non-conductive from the viewpoint that the film can be made not to cause electric leakage.

The die-bonding film 3, 3' of the dicing die-bonding film 10, 11 is preferably protected by a separator (not shown in the drawings). The separator has a function as a protective material to protect the die-bonding film 3,3' until the film is put to practical use. Further, the separator can be used also as a support base when the die-bonding film 3, 3' is transferred to the pressure-sensitive adhesive layer 2.
The separator is peeled off when the workpiece is pasted onto the die-bonding film 3, 3' of the dicing die-bonding film. Polyethylene terephthalate (PET), polyethylene, polyprolylene, a plastic film whose surface is coated with a peeling agent such as a fluorine peeling agent or a long-chain alkylacrylate peeling agent, paper, and the like can also be used as the separator.

### Method of Manufacturing Dicing Die-Bonding Film

Next, a method of manufacturing the dicing die-bonding film of the present invention is explained using the dicing die-bonding film 10 as an example. First, the base 1 can be formed by a conventionally known film formation method. Examples of the film formation method include a calender film formation method, a casting method in an organic solvent, an inflation extrusion method in a sealed system, a T-die extrusion method, a co-extrusion method, and a dry lamination method.

Next, the pressure-sensitive adhesive layer 2 is formed by applying a composition containing a pressure-sensitive adhesive onto the base 1, drying the composition, (and crosslinking the composition by heating as necessary). Examples of the application method include roll coating, screen coating, and gravure coating. Further, the application may be performed directly onto the base 1 or the composition may be transferred onto the base 1 after being applied onto release paper of which surface is subjected to a peeling treatment.

Next, the coating layer is formed by applying a forming material to form the die-bonding film 3 onto the release paper to a prescribed thickness and drying the material under a prescribed condition. The die-bonding film 3 is formed by transferring this coating layer onto the pressure-sensitive adhesive layer 2. Further, the die-bonding film 3 can also be formed by directly applying the forming material onto the pressure sensitive adhesive layer 2 and then drying the material under a prescribed condition. With this operation, the dicing die-bonding film 10 of the present invention can be obtained.

### Method of Manufacturing Semiconductor Device

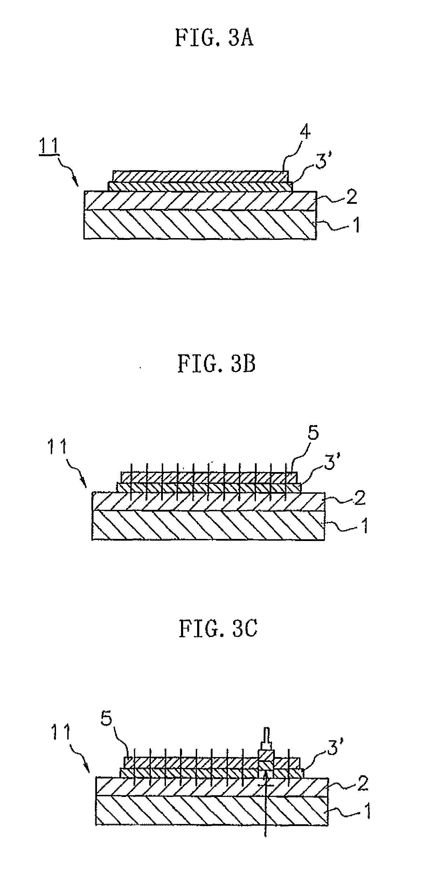

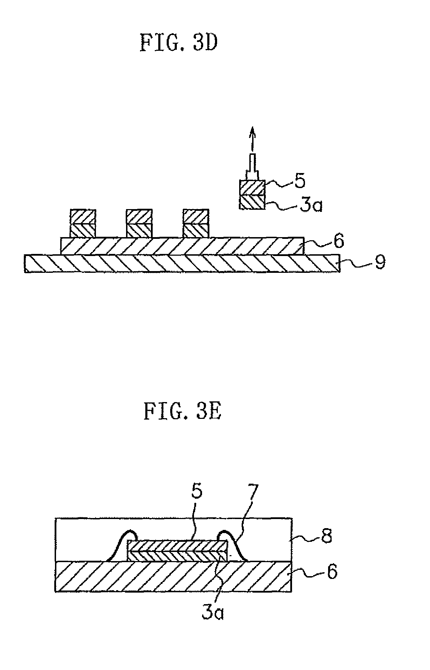

The separator that is optionally provided onto the die-bonding film 3, 3' is appropriately peeled off, and the dicing die-bonding film 10, 11 of the present invention is used as follows. The manufacturing method is explained below referring to Fig. 3 using the case of the dicing die-bonding film 11 as an example.

First, a semiconductor wafer 4 is fixed onto the die-bonding film 3' in the dicing die-bonding film 11 by press-bonding and by adhering and holding (mounting step). The present step is performed while pressing with a pressing means such as a press-bonding roll.

Next, dicing of the semiconductor wafer 4 is performed. With this operation, a semiconductor chip 5 is formed by cutting the semiconductor wafer 4 into a prescribed size to make it into individual pieces. The dicing is performed following an ordinary method from the circuit face side of the semiconductor wafer 4, for example. Further, a cutting method, so-called full cut, in which cutting-in is performed to the dicing die-bonding film 10, can be adopted in the present step, for example.
The dicing apparatus that is used in the present step is not especially limited, and a conventionally known apparatus can be used. Further, because the semiconductor wafer is adhered and fixed by the dicing die-bonding film 10, chip breakage and chip fly can be suppressed, and at the same time, damage of the semiconductor wafer 4 can be suppressed.

Picking up of the semiconductor chip 5 is performed to peel off the semiconductor chip that is adhered and fixed to the dicing die-bonding film 10. The method of picking up is not especially limited, and various conventionally known methods can be adopted. Examples thereof include a method of pushing up an individual semiconductor chip 5 from the dicing die-bonding film 10 side using a needle and picking up the semiconductor chip 5 that is pushed up with a picking up apparatus.

Here, the pick up can be performed after irradiating the pressure-sensitive adhesive layer 2 with the ultraviolet ray because the pressure-sensitive adhesive layer 2 is of an ultraviolet-ray curing-type. With this operation, the adhesive strength of the pressure-sensitive adhesive layer 2 to the die-bonding film 3a decreases, and the semiconductor chip 5 is easily peeled off. As a result, the pickup becomes possible without damaging the semiconductor chip.
The conditions during ultraviolet ray irradiation such as the radiation strength and the radiation time are not especially limited, and may be appropriately set as necessary. For example, the cumulative radiation of the ultraviolet ray is preferably 50 to 500 mJ/cm². Even in the above-described range of the cumulative radiation, peeling of the die-bonding film of the present invention does not become difficult due to excessive crosslinking by the ultraviolet ray irradiation, and the die-bonding film of the present invention exhibits a good pickup property. Further, the above-described one can be used for the ultraviolet ray irradiation.

The semiconductor chip 5 that is picked up is adhered and fixed to an adherend 6 interposing the die-bonding film 3a therebetween (die bonding). The adherend 6 is loaded on a heat block 9. Examples of the adherend 6 include a lead frame, a TAB film, a substrate, and a semiconductor chip that is separately produced. The adherend 6 may be a deformable adherend that can be deformed easily or may be a non-deformable adherend such as a semiconductor wafer that is difficult to be deformed.

As the substrate, a conventionally known one can be used. Further, metal lead frames such as a Cu lead frame and a 42 Alloy lead frame and an organic substrate made of glass epoxy, BT (Bismaleimide-Triazine), polyimide, and the like can be used as the lead frame. However, the present invention is not limited to the above-described ones, and a circuit substrate is also included in which a semiconductor element is mounted and that can be used by being electrically connected with the semiconductor element.

When the die-bonding film 3 is of a thermosetting type, the heat resistant strength is improved by adhering and fixing the semiconductor chip 5 to the adherend 6 by heat-curing. The substrate or the like to which the semiconductor chip 5 is adhered and fixed interposing the semiconductor wafer pasting portion 3a therebetween can be subjected to a reflow step.
Thereafter, wire bonding is performed to electrically connect the tip of the terminals (inner lead) of the substrate and an electrode pad (not shown in the drawings) on the semiconductor chip 5 with a bonding wire 7, the semiconductor chip is sealed with a sealing resin 8, and the sealing resin 8 is after-cured. With this operation, the semiconductor device of the present embodiment is produced.

Below, preferred examples of the present invention are explained in detail. However, materials, addition amounts, and the like described in these examples are not intended to limit the scope of the present invention, and are only examples for explanation as long as there is no description of limitation in particular. In the examples, the word "part(s)" represent "part(s) by weight", respectively, unless otherwise specified.

### Example 1

### Production of Dicing Film

An acrylic polymer A having a weight average molecular weight of 580,000 was obtained by placing 51.7 parts of 2-ethylhexyl acrylate (in the following, referred to as "2EHA"), 39.0 parts of stearyl acrylate (in the following, referred to as "SA"), 9.3 parts of 2-hydroxyethyl acrylate (in the following, referred to as "HEA"), 0.2 part of benzoyl peroxide, and 65 parts of toluene in a reactor equipped with a cooling tube, a nitrogen-introducing tube, a thermometer, and a stirring apparatus, and performing a polymerization treatment at 61 °C in a nitrogen airflow for 6 hours. The weight average molecular weight is as follows. The molar ratio of 2EHA, SA, and HEA was made to be 70 mol : 30 mol : 20 mol.

An acrylic polymer A' was obtained by adding 10.0 parts (80 mol% to HEA) of 2-methacryloyloxyethyl isocyanate (in the following, referred to as "MOI") into this acrylic polymer A and performing an addition reaction treatment at 50 °C in an air flow for 48 hours.

Next, a pressure-sensitive adhesive solution was produced by adding 8 parts of a polyisocyanate compound (trade name "CORONATE L" manufactured by Nippon Polyurethane Industry Co., Ltd.) and 5 parts of a photopolymerization initiator (trade name "IRGACURE 651" manufactured by Chiba Specialty Chemicals) into 100 parts of the acrylic polymer A'.

A pressure-sensitive adhesive layer having a thickness of 10 µm was formed by applying the prepared pressure-sensitive adhesive solution onto the surface of a PET peeling liner where a silicone treatment was performed and heat-crosslinking the product at 120 °C for 2 minutes. Next, a polyolefin film having a thickness of 100 µm was pasted onto the corresponding surface of the pressure-sensitive adhesive layer. After that, the product was kept at 50 °C for 24 hours, and the dicing film according to the present example was produced.

### Production of Die-Bonding Film

59 parts of an epoxy resin 1 (trade name "EPICOAT 1004" manufactured by Japan Epoxy Resins Co., Ltd.), 53 parts of an epoxy resin 2 (trade name "EPICOAT 827 manufactured by Japan Epoxy Resins Co., Ltd.), 121 parts of a phenol resin (trade name "MILEX XLC-4L" manufactured by Mitsui Chemicals, Inc.), and 222 parts of spherical silica (trade name "SO-25R" manufactured by Admatechs) to 100 parts of an acrylic ester polymer (trade name "PARACRON W-197CM" manufactured by Negami Chemical Industrial Co., Ltd.) containing ethyl acrylate-methyl methacrylate as a main component were dissolved into methylethylketone, and the mixture was prepared so that the concentration became 23.6% by weight.

This solution of the pressure-sensitive adhesive composition was applied onto a release treatment film made of a polyethylene terephthalate film having a thickness of 38 µm on which a silicone release treatment was performed as a peeling liner (separator), and then dried at 130 °C for 2 minutes. With this operation, a die-bonding film having a thickness of 25 µm was produced. Furthermore, the dicing die-bonding film of the present example was obtained by transferring the die-bonding film to the pressure-sensitive adhesive layer side in the dicing film.

### Measurement of Weight Average Molecular Weight Mw

The measurement of the weight average molecular weight Mw was performed by GPC (Gel Permeation Chromatography). The measurement condition is as follows. The weight average molecular weight was calculated by polystyrene conversion.

Measurement apparatus: HLC-8124GPC (trade name) manufactured by Tosoh Corporation
Column: TSKgel GMH-H(S) × 2 (product number) manufactured by Tosoh Corporation
Flow rate: 0.5 1/min
Amount injected: 100 µl
Column temperature: 40 °C
Eluent: THF
Concentration of injected sample: 0.1% by weight
Detector: differential refractometer

### Examples 2 to 15

In each of Examples 2 to 15, the dicing die-bonding film was produced in the same manner as in Example 1 except that the composition and the compounded ratio were changed to those shown in Table 1.

**Table 1**

| | ACRYLIC ESTER A | | ACRYLIC ESTER B | | | HYDROXYL GROUP-CONTAINING MONOMER | | ISOCYANATE COMPOUND | | | | |
|---|---|---|---|---|---|---|---|---|---|---|---|---|
| | 2EHA | i-OA | SA | VA | BA | HEA | 4HBA | MOI | AOI | TOLUENE | C/L | PHOTO POLYMERIZATION INITIATOR |
| EXAMPLE 1 | 51.7 (70) | - | 39.0 (30) | - | - | 9.3 (20) | - | 10.8 (80) | | 65 | 8 | 5 |
| EXAMPLE 2 | 53.7 (70) | - | 40.5 (30) | - | - | 5.8 (12) | - | 6.4 (83) | - | 65 | 8 | 5 |
| EXAMPLE 3 | 49.4 (70) | -- | 37.3 (30) | - | - | 13.3 (30) | - | 14.3 (80) | - | 65 | 8 | 5 |
| EXAMPLE 4 | 68.5 (85) | - | 21.3 (15) | - | - | 10.2 (20) | - | 10.9 (80) | - | 65 | 8 | 5 |
| EXAMPLE 5 | 46.7 (65) | - | 44.3 (35) | - | - | 9.1 (20) | - | 9.7 (80) | - | 65 | 8 | 5 |
| EXAMPLE 6 | - | 51.7 (70) | 39.0 (30) | - | - | 9.3 (20) | - | 10.0 (80) | - | 65 | 8 | 5 |
| EXAMPLE 7 | 50.6 (70) | | 38.2 (30) | - | - | - | 11.3 (20) | 9.7 (80) | - | 65 | 8 | 5 |
| EXAMPLE 8 | 51.7 (70) | | 39.0 (30) | - | - | 9.3 (20) | - | - | 9.1 (80) | 65 | 8 | 5 |
| EXAMPLE 9 | 51.7 (70) | | 39.0 (30) | - | - | 9.3 (20) | - | 8.7 (70) | - | 65 | 8 | 5 |
| EXAMPLE 10 | 51.7 (70) | | 39.0 (30) | - | - | 9.3 (20) | - | 11.2 (90) | - | 65 | 8 | 5 |
| EXAMPLE 11 | 51.7 (70) | | 39.0 (30) | - | - | 9.3 (20) | - | 10.0 (80) | - | 100 | - | 5 |
| EXAMPLE 12 | 51.7 (70) | | 39.0 (30) | - | - | 9.3 (20) | - | 10.0 (80) | - | 40 | 8 | 5 |
| EXAMPLE 13 | 51.7 (70) | | 39.0 (30) | - | - | 9,3 (20) | - | 10.0 (80) | - | 65 | 4 | 5 |
| EXAMPLE 14 | 51.7 (70) | | 39.0 (30) | - | - | 9.3 (20) | - | 10.0 (80) | - | 65 | 15 | 5 |
| EXAMPLE 15 | 59.8 (80) | | - | 30.8 (20) | | 9.4 (20) | - | 10.0 (80) | - | 65 | 8 | 5 |

| | | | | | | | | | | | | |
|---|---|---|---|---|---|---|---|---|---|---|---|---|
| The values in parentheses represent mol%. However, the values in parentheses in HEA and 4HBA represent mol% to 100 mol% of the total amount of the acrylic ester. Further, the values in parentheses in MOI and AOI represent mol% to the hydroxyl group-containing monomer. | | | | | | | | | | | | |

The meaning of the abbreviations described in Table 1 and the following Table 2 is as follows.

2EHA: 2-ethylhexyl acrylate
i-OA: isooctyl acrylate
SA: stearyl acrylate
VA: behenyl acrylate
BA: n-butyl acrylate
HEA: 2-hydroxyethyl acrylate
4HBA: 4-hydroxybutyl acrylate
AOI: 2-acryloyloxyethyl isocyanate
C/L: polyisocyanate compound (trade name "CORONATE L"
manufactured by Nippon Polyurethane Industry Co., Ltd.)

### Comparative Examples 1 to 7

In each of Comparative Examples 1 to 7, the dicing die-bonding film was produced in the same manner as in Example 1 except that the composition and the compounded ratio were changed to those shown in Table 2.

**Table 2**

| | ACRYLIC ESTER A | | ACRYLIC ESTER B | | | HYDROXYL GROUP-CONTAINING MONOMER | | ISOCYANATE COMPOUND | | | | |
|---|---|---|---|---|---|---|---|---|---|---|---|---|
| | 2EHA | i-OA | SA | VA | BA | HEA | 4HBA | MOI | AOI | TOLUENE | C/L | PHOTO POLYMERIZATION INITIATOR |
| COMPARATIVE EXAMPLE 1 | - | - | 34.0 (20) | - | 53.8 (80) | 12.2 (20) | - | 13.0 (80) | - | 65 | 8 | 5 |
| COMPARATIVE EXAMPLE 2 | 56.4 (70) | - | 42.6 (30) | - | - | 1.0 (2) | - | 1.1 (80) | - | 65 | 8 | 5 |
| COMPARATIVE EXAMPLE 3 | 45.4 (70) | - | 34.2 (30) | - | - | 20.4 (50) | - | 21.8 (80) | - | 65 | 8 | 5 |
| COMPARATIVE EXAMPLE 4 | 51.7 (70) | - | 39.0 (30) | - | - | 9.3 (20) | - | 6.2 (50) | - | 65 | 8 | 5 |
| COMPARATIVE EXAMPLE 5 | 81.6 (95) | - | 7.6 (5) | - | - | 10.8 (20) | - | 11.6 (80) | - | 65 | 8 | 5 |
| COMPARATIVE EXAMPLE 6 | 25.3 (40) | - | 66.8 (60) | - | - | 8.0 (20) | - | 8.5 (80) | - | 65 | 8 | 5 |
| COMPARATIVE EXAMPLE 7 | 51.7 (70) | - | 39.0 (30) | - | - | 9.3 (20) | - | 12.4 (100) | - | 65 | 8 | 5 |

| | | | | | | | | | | | | |
|---|---|---|---|---|---|---|---|---|---|---|---|---|
| The values in parentheses represent mol%. However, the values in parentheses in HEA and 4HBA represent mol% to 100 mol% of the total amount of the acrylic ester. Further, the values in parentheses in MOI and AOI represent mol% to the hydroxyl group-containing monomer. | | | | | | | | | | | | |

### Dicing

The dicing of the semiconductor was actually performed in the following manner using each of the dicing die-bonding films of the examples and comparative examples, and performance of each dicing die-bonding film was evaluated.

A backside polishing treatment was performed on a semiconductor wafer (8 inch in diameter and 0.6 mm in thickness), and a mirror wafer having a thickness of 0.15 mm was used as a workpiece. The separator was peeled off the dicing die-bonding film, the mirror wafer was pasted onto the die-bonding film by roll press-bonding at 40 °C, and dicing was performed. Further, the dicing was performed to full-cut so that the chips had a size of 1 mm².
Whether chip fly occurred or not was confirmed on the semiconductor wafer and on the dicing die-bonding film after cutting. The chip fly was evaluated in the following manner: the case that any semiconductor chip flew is marked as poor and the case that no semiconductor chip flew is marked as good. The wafer grinding condition, the pasting condition, and the dicing condition are described later.

### Wafer Grinding Condition

Grinding apparatus: DFG-8560 manufactured by DISCO Corporation
Semiconductor wafer: 8 inch in diameter (the backside was polished to a thickness of 0.6 mm to 0.15 mm.)

### Pasting Conditions

Pasting apparatus: MA-3000II manufactured by Nitto Seki Co., Ltd.
Pasting speed: 10 mm/min
Pasting pressure: 0.15 MPa
Stage temperature during pasting: 40 °C

### Dicing Conditions

Dicing apparatus: DFD-6361 manufactured by DISCO Corporation
Dicing ring: 2-8-1 manufactured by DISCO Corporation
Dicing speed: 80 mm/sec

### Dicing blade:

Z1: 2050HEDD manufactured by DISCO Corporation
Z2: 2050HEBB manufactured by DISCO Corporation

### Dicing blade rotational speed:

Z1: 40,000 rpm
Z2: 40,000 rpm

### Blade height:

Z1: 0.215 mm (depending on the thickness of the semiconductor wafer (When the wafer thickness is 75 µm, it is 0.170 mm.))
Z2: 0.085 mm
Cutting method: A mode / Step cut
Wafer chip size: 1.0 mm².

### Picking Up

The picking up was actually performed after the dicing of the semiconductor wafer was performed in the following manner using each of the dicing die-bonding films of the examples and comparative examples, and performance of each dicing die-bonding film was evaluated.

A backside polishing treatment was performed on a semiconductor wafer (8 inch in diameter and 0.6 mm in thickness), and a mirror wafer having a thickness of 0.075 mm was used as a workpiece. The separator was peeled off the dicing die-bonding film, the mirror wafer was pasted onto the die-bonding film by roll press-bonding at 44 °C, and dicing was performed. Further, the dicing was performed to full-cut so that the chips had a size of 10 mm square.

Next, ultraviolet irradiation was performed on each dicing die-bonding film, and the expanding step was performed by stretching the film to make the space between chips a prescribed interval. Furthermore, the evaluation of the pick up property was performed by picking up the semiconductor chip by a method of pushing up the semiconductor chip using a needle from the base side of each dicing die-bonding film. Specifically, 400 semiconductor chips were continuously picked up, and the success rate was shown when the picking up was performed under the following conditions.

### Wafer Grinding Conditions

Grinding apparatus: DFG-8560 manufactured by DISCO Corporation
Semiconductor wafer: 8 inch in diameter (the backside was polished to a thickness of 0.6 mm to 0.050 mm.)

### Pasting Conditions

Pasting apparatus: MA-3000II manufactured by Nitto Seki Co., Ltd.
Pasting speed: 10 mm/min
Pasting pressure: 0.15 MPa
Stage temperature during pasting: 40 °C

### Dicing Conditions

Dicing apparatus: DFD-6361 manufactured by DISCO Corporation
Dicing ring: 2-8-1 manufactured by DISCO Corporation
Dicing speed: 80 mm/sec

### Dicing blade:

Z1: 2050HEDD manufactured by DISCO Corporation
Z2: 2050HEBB manufactured by DISCO Corporation

### Dicing blade rotational speed:

Z1: 40,000 rpm
Z2: 40,000 rpm

### Blade height:

Z1: 0.170 mm (depending on the thickness of the semiconductor wafer (When the wafer thickness is 50 µm, it is 0.170 mm.))
Z2: 0.085 mm
Cutting method: A mode / Step cut
Wafer chip size: 10.0 mm square

### Ultraviolet Ray Irradiation Conditions

Ultraviolet ray irradiation apparatus: UM-810 manufactured by Nitto Seiki Co., Ltd.
Ultraviolet ray cumulative radiation: 300 mJ/cm²
The ultraviolet ray irradiation was performed from the polyolefin film side.

### Picking Up Conditions

The picking up was performed under each of the conditions shown in the following Table 3.

**Table 3**

| NEEDLE | TOTAL LENGTH 10 mm, DIAMETER 0.7 mm, SHARP ANGLE 15 degrees, TIP R 350 µm |
|---|---|
| NUMBER OF NEEDLES | 9 |
| NEEDLE PUSHING UP AMOUNT (µm) | 250 |
| NEEDLE PUSHING UP SPEED (mm/sec) | 5 |
| COLLET MAINTAINING TIME (msec) | 1000 |
| EXPANDING SPEED (mm/sec) | 3 |

### Method of Measuring Tensile Modulus

As the measurement conditions, the sample size was made to be an initial length of 10 mm and a sectional area of 0.1 to 0.5 mm², the measurement temperature was made to be 23 °C, the distance to the chuck was made to be 50 mm, and the tensile test was performed in the MD direction or the TD direction at a tensile speed of 50 mm/min, and the variation in elongation (mm) of the sample in each direction was measured.
As a result, the tensile modulus was obtained by drawing a tangent line at the initial rising part of the obtained S-S curve and dividing the tensile strength when the tangent line corresponds to 100% elongation by the sectional area of the base film. Measurement of the tensile modulus after the ultraviolet ray irradiation was performed after the sample was irradiated with an ultraviolet ray from the polyolefin film side under the above-described irradiation conditions.

### Peeling Adhesive Strength

A sample piece having a width of 10 mm was cut out from each dicing die-bonding film, and was pasted onto a silicon mirror wafer placed on a hot plate at 40 °C. After the sample piece was left for about 30 minutes, the sample was irradiated with the ultraviolet ray from the dicing film side, and the peeling adhesive strength was measured using a tensile test machine. The measurement conditions were a peeling angle of 15° and a tensile speed of 300 mm/min. Conservation and measurement of the peeling adhesive strength of the sample piece were performed under an environment of a temperature of 23 °C and a relative humidity of 50%. The irradiation conditions of the ultraviolet ray were as follows.

### Irradiation Conditions of the Ultraviolet Ray

Ultraviolet ray (UV) irradiation apparatus: high pressure mercury lamp
Ultraviolet ray cumulative radiation: 500 mJ/cm²
Output: 75 W
Irradiation strength: 150 mW/cm²

**Table 4**

| | Mw (ten thousands) | TENSILE STORAGE MODULUS (MPa) | TENSILE STORAGE MODULUS AFTER UV CURING(MPA) | PEELING ADHESIVE STRENGTH (N/10 mm) | PICK UP (%) | CHIPFLY |
|---|---|---|---|---|---|---|
| EXAMPLE 1 | 54 | 1.0 | 16.1 | 1.13 | 100.0 | ○ |
| EXAMPLE 2 | 50 | 0.7 | 10.3 | 1.20 | 99.8 | ○ |
| EXAMPLE 3 | 60 | 1.6 | 70.9 | 1.16 | 100.0 | ○ |
| EXAMPLE 4 | 58 | 1.0 | 18.4 | 1.26 | 99.5 | ○ |
| EXAMPLE 5 | 53 | 1.2 | 19.4 | 1.03 | 100.0 | ○ |
| EXAMPLE 6 | 54 | 1.2 | 16.2 | 1.15 | 100.0 | ○ |
| EXAMPLE 7 | 53 | 1.0 | 17.2 | 1.10 | 100.0 | ○ |
| EXAMPLE 8 | 54 | 1.0 | 16.0 | 1.11 | 100.0 | ○ |
| EXAMPLE 9 | 54 | 1.0 | 12.3 | 1.21 | 99.8 | ○ |
| EXAMPLE 10 | 54 | 1.0 | 20.7 | 1.19 | 100.0 | ○ |
| EXAMPLE 11 | 40 | 0.9 | 15.8 | 1.14 | 100.0 | ○ |
| EXAMPLE 12 | 85 | 1.0 | 16.8 | 1.21 | 100.0 | ○ |
| EXAMPLE 13 | 54 | 0.6 | 8.7 | 1.21 | 99.5 | ○ |
| EXAMPLE 14 | 54 | 2.0 | 25.4 | 1.15 | 100.0 | ○ |
| EXAMPLE 15 | 55 | 1.2 | 15.8 | 1.09 | 100.0 | ○ |

**Table 5**

| | Mw (ten thousands) | TENSILE STORAGE MODULUS (MPa) | TENSILE STORAGE MODULUS AFTER UV CURING (MPa) | PEELING ADHESIVE STRENGTH (N/10 mm) | PICK UP (%) | CHIPFLY |
|---|---|---|---|---|---|---|
| COMPARATIVE EXAMPLE 1 | 76 | 1.4 | 78.4 | 1.80 | 0.0 | ○ |
| COMPARATIVE EXAMPLE 2 | 52 | 0.4 | 6.7 | 1.57 | 25.5 | ○ |
| COMPARATIVE EXAMPLE 3 | 59 | 2.4 | 115 | 1.55 | 21,0 | ○ |
| COMPARATIVE EXAMPLE 4 | 54 | 0.8 | 10.5 | 1.47 | 0.0 | ○ |
| COMPARATIVE EXAMPLE 5 | 57 | 1.0 | 17.1 | 1.44 | 2.5 | ○ |
| COMPARATIVE EXAMPLE 6 | 52 | 1.3 | 17.4 | 0.84 | 100.0 | × |
| COMPARATIVE EXAMPLE 7 | 54 | 0.5 | 23.1 | 1.53 | 24.0 | ○ |

## Claims

1. A dicing die-bonding film comprising a dicing film having a pressure-sensitive adhesive layer (2) on a base (1) and a die-bonding film (3) provided on the pressure-sensitive adhesive layer (2),
wherein the pressure-sensitive adhesive layer (2) is formed from an acrylic polymer comprising an acrylic ester A represented by CH₂=CHCOOR¹ (wherein R¹ is an alkyl group having 6 to 10 carbon atoms), an acrylic ester B represented by CH₂=CHCOOR²
(wherein R² is an alkyl group having 11 carbon atoms or more), a hydroxyl group-containing monomer, and an isocyanate compound having a radical reactive carbon-carbon double bond within a molecule, the compounded ratio of the acrylic ester A and the acrylic ester B is 40 to 10 mol% of the acrylic ester B to 60 to 90 mol% of the acrylic ester A,
the compounded ratio of the hydroxyl group-containing monomer is in a range of 10 to 30 mol% to 100 mol% of the total of the acrylic ester A and the acrylic ester B,
the compounded ratio of the isocyanate compound is in a range of 70 to 90 mol% to 100 mol% of the hydroxyl group-containing monomer, and
the die-bonding film is formed from an epoxy resin.

2. The dicing die bond film according to claim 1,
wherein the hydroxyl group-containing monomer is at least any one selected from a group consisting of 2-hydroxyethyl (meth)acrylate, 2-hydroxypropyl (meth)acrylate, 4-hydroxybutyl (meth)acrylate, 6-hydroxyhexyl (meth)acrylate, 8-hydorxyoctyl (meth)acrylate, 10-hydroxydecyl (meth)acrylate, 12-hydroxylauryl (meth)acrylate, and (4-hydroxymethylcyclohexyl)methyl (meth)acrylate.

3. The dicing die bond film according to claim 1 or 2,
wherein the isocyanate compound having a radical reactive carbon-carbon double bond is at least one of 2-methacryloyloxyethyl isocyanate and 2-acrylolyloxyethyl isocyanate.

4. The dicing die bond film according to any of claims 1 to 3,
wherein the weight average molecular weight of the acrylic polymer is in a range of 350,000 to 1,000,000.

5. The dicing die-bonding film according to any of claims 1 to 4,
wherein the tensile modulus at 23 °C of the pressure-sensitive adhesive layer (2) before ultraviolet irradiation is in a range of 0.4 to 3.5 MPa and the tensile modulus at 23 °C after ultraviolet irradiation is in a range of 7 to 100 MPa.

6. The dicing die bond film according to any of claims 1 to 5,
wherein the acrylic polymer comprising the pressure-sensitive adhesive layer does not contain an acrylic acid as a monomer component.
